# EUROPÄISCHE PATENTSCHRIFT

(11) **EP 2 258 547 B1**
(45) Veröffentlichungstag und Bekanntmachung des Hinweises auf die Patenterteilung: **14.03.2012**
(21) Anmeldenummer: 10004901.4
(22) Anmeldetag: 10.05.2010
(51) Int. Cl.: B32B 27/08, B32B 27/36, B32B 27/32, H01L 31/048

(54) **Coextrudierte, biaxial orientierte Polyesterfolien mit verbesserten Hafteigenschaften, Rückseitenlaminate für Solarmodule und Solarmodule**
Coextruded biaxial oriented polyester films with improved adhesive characteristics, rear laminates for solar modules and solar modules
Feuilles de polyester coextrudées, orientées de manière biaxiale et dotées de propriétés d'adhésion améliorées, laminés de faces arrière pour modules solaires et modules solaires

(30) Priorität: 18.05.2009 DE 102009021712
(43) Veröffentlichungstag der Anmeldung: 08.12.2010
(73) Patentinhaber: Mitsubishi Polyester Film GmbH, 65203 Wiesbaden (DE)
(72) Erfinder: Kliesch, Holger, Dr., 65462 Ginsheim (DE); Peiffer, Herbert, Prof. Dr., 55126 Mainz (DE); Bothe, Lothar, Dr., 55124 Mainz (DE)
(74) Vertreter: Schweitzer, Klaus

(56) Entgegenhaltungen:
- EP-A1- 1 826 826
- US-A- 4 640 870
- US-A1- 2008 264 481

## Beschreibung

Die Erfindung betrifft coextrudierte, biaxial orientierte Polyesterfolien mit verbesserten Hafteigenschaften, Rückseitenlaminate für Solarmodule umfassend die coextrudierten, biaxial orientierten Polyesterfolien und die Solarmodule selbst. Die Erfindung bezieht sich insbesondere auf coextrudierte, biaxial orientierte Polyesterfolien, die eine sehr gute Haftung zu Ethylen-Vinylacetat-Copolymeren (EVA-Copolymere) aufweisen, die als Einkapselungsmittel für Solarzellen eingesetzt werden und mindestens eine coextrudierte Deckschicht aufweisen, die eine spezielle Zusammensetzung aufweist. Weiterhin betrifft die Erfindung ein Folienlaminat als Rückseitenschutz von Solarmodulen umfassend die erfindungsgemäße Folie mit sehr guter Haftung zum Einkapselungsmaterial EVA der Solarzellen und die Solarzellen selbst.

Photovoltaische Module oder Solarmodule dienen zur elektrischen Energieerzeugung aus Sonnenlicht und bestehen aus einem Laminat, welches als Kernschicht ein Solarzellensystem wie z. B. Siliziumsolarzellen enthält. Diese Siliziumsolarzellen sind jedoch mechanisch nur gering belastbar und müssen daher geschützt werden. Die Solarzellen sind mit Einkapselungsmaterial, das üblicherweise aus vernetztem EVA besteht, umhüllt, um einen Schutz gegen mechanische und witterungsbedingte Einflüsse zu gewährleisten.

Pholtovoltaische Module bestehen dabei in der Regel aus einer Vorderschicht aus einem Material mit hoher Lichtdurchlässigkeit, die in der Regel aus Glas besteht, den Solarzellen, die von dem Einbettungsmittel umgeben sind, und einer Rückseitenschutzfolie oder einem Rückseitenschutzfolienlaminat, dem so genannten Backsheet, das zum Schutz gegen mechanische und Umwelteinflüsse und zur elektrischen Isolierung dient.

Als Front von Solarmodulen werden in der Regel Schichten mit hoher Lichtdurchlässigkeit, insbesondere eisenarme Gläser mit möglichst hoher Lichtdurchlässigkeit im Bereich von 380 bis 1200 nm, eingesetzt, deren Außenschicht oft noch durch eine chemische Behandlung mit H₂SiF₆ texturiert wird, um die Lichtdurchlässigkeit weiter zu erhöhen. Die Ethylen-Vinylacetat-Copolymeren werden zur Verbesserung ihrer Eigenschaften (Einkapselung der Solarzellen) mit Additiven modifiziert wie z. B. lösliche UV-Stabilisatoren (z. B. Tinuvin^{®} 770) und Lichtschutzmitteln (z. B. Naugard^{®} P). Damit es im Laminierschritt zu einer Vernetzung des Ethylen-Vinylacetats kommt, enthalten die Ethylen-Vinylacetat-Copolymere weiterhin Vernetzer, insbesondere peroxidischer Natur (z. B. Lupersol^{®} 101; Lupersol TBEC). Eine Darstellung zum Einsatz von EVA als Einkapselungsmaterial für Solarzellen ist z. B. in "Application of Ethylene Vinyl Acetate as an Encapsulationg Material for Terrestrial Photovoltaic Modules" (JPL Publication 83-85, April 15, 1983) und in US-A-6,093,757 zu finden.

Verfahren zur Herstellung von Solarmodulen und die Einkapselung von photovoltaischen Zellen sind aus WO-A-94/29106, WO-A-01/67523, WO-A-00/02257 und WO 2007/009140 bekannt. Es handelt sich bei diesen Verfahren um Laminierverfahren, insbesondere um Vakuumlaminierverfahren.

Als Rückseitenfolien oder Rückseitenlaminate für photovoltaische Module wurden bereits eine Vielzahl von Konstruktionen vorgeschlagen. Vorschläge für Rückseitenlaminate sind z. B. in "Performance of Encapsulating Systems" (19th European Photovoltaic Solar Energy Conference, 1-11 June 2004, Paris, France auf Seite 2153 -2155), EP-A-1 930 953 oder WO-A-00/74935 zu finden.

In vielen vorgeschlagenen Konstruktionen wird der Einsatz von biaxial orientierten Polyesterfolien empfohlen. Biaxial orientierte Polyesterfolien zeichnen sich aufgrund der Orientierung durch ausgezeichnete mechanische Eigenschaften, Wärmebeständigkeit, geringe Wasserdampfdurchlässigkeit und gute elektrische Isoliereigenschaften aus. Allerdings weisen biaxial orientierte Polyesterfolien wegen ihrer Polarität und hohen Kristallinität eine unbefriedigende Haftung zu dem Einkapselungsmaterial EVA der Solarzellen auf.

Werden biaxial orientierten Polyesterfolien direkt an das Einbettungsmaterial der Solarzellen laminiert, so sind die erreichten Haftungen und Langzeithaftungen ungenügend wie z. B in "Performance of Encapsulating Systems" (19th European Photovoltaic Solar Energy Conference, 1-11 June 2004, Paris, France) und EP-A-1 826 826 dargelegt wird.

Zur Verbesserung der Hafteigenschaften von biaxial orientierten Polyesterfolien zum Einbettungsmaterial wurde daher bereits in der EP-A-1 826 826 vorgeschlagen, die Polyesterfolienoberfläche mit speziellen Haftvermittlerbeschichtungen zu versehen, die während der Polyesterfolienherstellung nach der ersten Streckung aufgetragen und aus speziellen Copolyestern und/oder Acrylaten bestehen, die mittels eines Vernetzers vernetzt werden. Die Vorschläge in EP-A-1 826 826 sind aber noch unbefriedigend. Aufgrund des notwendigen zusätzlichen Beschichtungsschrittes ist die Herstellung dieser Folien aufwändig. Weiterhin führt die Vernetzung der Beschichtung zu Schwierigkeiten bei der Regenerierung (o. a. Rezyklierung) der Folien und beim Wiedereinsatz des Folieneigenregenerats bei der Folienherstellung. Der Wiedereinsatz des Folieneigenregenerats bei der Folienherstellung führt zu einer Verfärbung und Verstippung der Folie. Der vorgeschlagene In-line-Antrag der Haftvermittlerschicht ist weiterhin aufwändig und kostspielig. Erstens ist für die Beschichtung eine spezielle Beschichtungsanlage notwendig. Zweitens muss ein Lösungsmittel verdampft werden, und es ist ein zusätzlicher Kontrollaufwand notwendig, um die Beschichtungsqualität zu beurteilen. Bei bekannten In-line-Beschichtungsverfahren ist es zudem schwierig, unter wirtschaftlich sinnvollen Randbedingungen größere Schichtdicken aufzubringen. Realistische Schichtdicken liegen hier in der Regel unterhalb von 0,4 µm und bei normalen Maschinengeschwindigkeiten und Antragsgewichten sogar unterhalb von 0,1 µm (s. EP-A-1 826 826, Beispiele). Dickere Schichten wären jedoch wünschenswert, um eine über die Anwendungszeit des Moduls stabile Haftkraft zu erreichen.

Es stellt sich daher die Aufgabe, eine biaxial orientierte Polyesterfolie für Rückseitenlaminate für photovoltaische Module bereitzustellen, die eine verbesserte Haftung zu dem Einkapselungsmaterial EVA aufweist, die auf einfache Weise hergestellt werden kann und deren Eigenregenerat problemlos eingesetzt werden kann.

Gelöst wird diese Aufgabe durch eine coextrudierte, biaxial orientierte Polyesterfolie, die aus einer Basisschicht und mindestens einer coextrudierten Oberflächenschicht besteht, die sowohl eine gute Haftung zur Basisschicht als auch sehr gute Anfangshaftung als auch Langzeithaftung gegenüber EVA aufweist.

Die coextrudierte, biaxial orientierte Polyesterfolie umfasst eine Basisschicht (B) und mindestens eine Deckschicht (A) wobei
(a) die Basisschicht (B) überwiegend aus thermoplastischem Polyester besteht und
(b) die Deckschicht (A) mit guter Haftung zu EVA überwiegend aus einer Mischung von
   50 - 97 Gew.-% Ethylen-Acrylsäureester-Copolymer und
   3 - 50 Gew.-% Polyesterpolymer
   besteht,
   wobei der Anteil an Acrylsäureester im Ethylen-Acrylsäureester-Copolymer 2,5 bis 15 Mol-% beträgt, bezogen auf die Monomeren des Copolymer.

Die erfindungsgemäße Folie wird direkt als Backsheet oder als Bestandteil eines Backsheetlaminats für ein Solarmodul eingesetzt, wobei die Deckschicht (A) dann das Einkapselungsmaterial der Solarzellen kontaktiert und eine gute Haftung (= Anfangs- und Langzeithaftung) zum EVA-Einkapselungsmaterial der Solarzellen bewirkt.

Die coextrudierte, biaxial orientierte Polyesterfolie gemäß der vorliegenden Erfindung ist mindestens zweischichtig aufgebaut. Sie besteht dann aus der Basisschicht (B) und der auf dieser Schicht mittels Coextrusion aufgebrachten Deckschicht (A) mit sehr guter Haftung zu EVA, insbesondere vernetztem EVA, und ebenfalls sehr guter Haftung zur Basisschicht (B). In einer besonderen Ausführungsform ist die Folie dreischichtig oder mehr als dreischichtig aufgebaut. Im Falle des dreischichtigen Aufbaus besteht sie aus der Basisschicht (B), der Deckschicht (A) und einer weiteren, der Deckschicht (A) gegenüberliegend angeordneten Deckschicht (C). Bei einer vier- oder fünfschichtigen Ausführungsform enthält die Folie zusätzlich noch Zwischenschichten zwischen der Basisschicht (B) und der Deckschicht (A) und/oder (C).

Die Basisschicht (B) besteht vorzugsweise zu mindestens 65 Gew.-%, bevorzugt zu mindestens 80 Gew.-% und besonders bevorzugt zu mindestens 85 Gew.-%, aus thermoplastischem Polyester. Der thermoplastische Polyester enthält aromatische Dicarbonsäuren, insbesondere Terephthalsäure, Isophtalsäure und Naphthalindicarbonsäure, sowie aliphatische Diole wie z. B. Ethylenglykol, Diethylenglykol und Butandiol. Die thermoplastischen Polyester können auch Copolyester sein. Insbesondere Copolyester basierend auf Terephthalsäure und Isophthalsäure in Kombination mit vorzugsweise Ethylenglykol als Diolkomponente seien genannt. Besonders bevorzugt als thermoplastische Polyester sind Polyethylenterephthalat (PET), Polyethylennaphthalat (PEN) und Copolymerisate aus Ethylenterephthalat und Ethylenisophthalat mit bevorzugt 3 bis 15 Gew.-% Ethylenisophthalatgehalt, wobei Polymere mit mindestens 90 Gew.-% (bezogen auf den Polymeranteil), bevorzugt mindestens 95 Gew.-% und insbesondere 98 Gew.-%, Polyethylenterephthalat ganz besonders bevorzugt sind. Die intrinsische Viskosität (IV) des Polyethylenterephthalats der Basisschicht ist größer als 0,5, bevorzugt größer 0,6, besonders bevorzugt 0,65 bis 0,85.

Der Basisschicht (B) können bis zu 35 Gew.-%, bevorzugt bis zu 20 Gew.-% und besonders bevorzugt bis zu 15 Gew.-%, übliche Additive, bezogen auf das Gewicht der Basisschicht (B), zugesetzt werden. Übliche Additive sind z. B. anorganische und organische Partikel, Farbstoffe und Farbpigmente, unverträgliche Polymere, Stabilisatoren wie z. B. UV-Stabilisatoren, Hydrolysestabilisatoren, Verarbeitungsstabilisatoren, Flammschutzmittel und Kettenverlängerer.

Die anorganischen und organischen Partikel können zur Verbesserung der Wickelbarkeit und der Weiterverarbeitungseigenschaften bzw. des Verarbeitungsverhaltens der Folie bei der Solarmodulherstellung dienen. Beispielhaft seien Partikel wie SiO₂, Kaolin, CaCO₃ und vernetzte Polystyrolpartikel genannt. Der mittlere Teilchendurchmesser liegt bevorzugt zwischen 0,05 bis 10 µm. Der Polyester kann durch Zusatz von Farbstoffen und Farbpigmenten eingefärbt sein. Unter dem Gesichtspunkt der Verbesserung der Reflexionseigenschaften gegenüber Licht zur Verbesserung der elektrischen Ausbeute der Solarzelle ist insbesondere der Zusatz von Weißpigmenten wie BaSO₄ und TiO₂ und insbesondere der Zusatz von TiO₂ in Mengen von 1 bis 25 Gew.-% vorteilhaft. Der Zusatz von TiO₂ ist dann besonders bevorzugt, wenn das TiO₂ anorganisch und/oder organisch beschichtet ist. Der Zusatz des TiO₂ bewirkt einerseits die Weißfärbung der Folie und führt aufgrund einer erhöhten Lichtreflexion zu einer Erhöhung der elektrischen Ausbeute beim Einsatz der Folie für Backsheets von Solarmodulen und anderseits zur Verbesserung der UV-Beständigkeit der Folie bzw. des Backsheets, was beim Außeneinsatz des Solarmoduls von besonderem Vorteil ist. Die anorganische Beschichtung reduziert die katalytisch wirksame Oberfläche des TiO₂, die zu einer Vergilbung der Folie führen kann, während sich die organische Beschichtung positiv auf die Einarbeitung des TiO₂ in den thermoplastischen Polyester auswirkt. Der mittlere Teilchendurchmesser d₅₀ des TiO₂ liegt bevorzugt im Bereich von 0,1 bis 0,5 µm, besonders bevorzugt bei 0,15 bis 0,3 µm. Die Zusatzmenge des TiO₂ liegt bevorzugt bei 3 bis 25 Gew.-%, insbesondere bevorzugt bei 4 bis 12 Gew.-%, besonders bevorzugt bei 5 bis 10 Gew.%.

Zur Verbesserung der Langzeitstabilität kann einer oder mehreren Schichten der Folie ein Hydrolyseschutzmittel zugesetzt werden. Bevorzugt werden 0,5 bis 15 Gew.-%, besonders bevorzugt 2 bis 6 Gew.-%, Hydrolyseschutzmittel zugesetzt. Bevorzugte Hydrolyseschutzmittel sind dabei epoxidierte Fettsäureester wie z. B. in EP-A-1 634 914 oder EP-A-1 639 915 beschrieben.

Neben der Zugabe von Hydrolysestabilisatoren kann bevorzugt auch ein Polyesterrohstoff mit niedrigem Carboxylendgruppengehalt (CEG) < 20 mmol/kg bzw. besonders bevorzugt mit einem Carboxylendgruppengehalt < 12 mmol/kg eingesetzt werden (gemessen wie in EP-A-0 738 749 angegeben), um eine verbesserte Hydrolysestabilität der Folie selbst zu erzeugen. Solche Rohstoffe sind kommerziell erhältlich bzw. können nach bekannten Verfahren hergestellt werden.

Die Basisschicht (B) kann bis zu 25 Gew.-%, bevorzugt bis zu 10 Gew.-% und besonders bevorzugt bis zu 7 Gew.-%, Ethylen-Acrylsäureester-Copolymerisat enthalten. Die Basisschicht (B) kann bevorzugt mindestens 1 Gew.-% und besonders bevorzugt mindestens 2 Gew.-%, Ethylen-Acrylsäureester-Copolymerisat enthalten, da dadurch die Haftung der Deckschicht (A) auf der Basisschicht (B) verbessert wird. Der Ethylen-Acrylsäureester-Copolymerisat-Anteil stammt dabei bevorzugt aus Folien-Eigenregenerat.

Die Additive können dem Polyesterpolymer der Basisschicht (B) während der Herstellung zugesetzt werden oder beispielsweise mittels Masterbatchtechnologie bei der Folienherstellung eingebracht werden.

Die durch Coextrusion aufgebrachte Deckschicht (A) besteht zur Erzielung der gewünschten Hafteigenschaften zu EVA und der Basisschicht (B) zu mindestens 75 Gew.-%, bevorzugt zu mindestens 85 Gew.-% und besonders bevorzugt zu mindestens 95 Gew.-%, aus einem Blend aus 50 bis 97 Gew.-% Ethylen-Acrylsäureester-Copolymerisat und 50 bis 3 Gew.-% Polyesterpolymer und bis zu 25 Gew.-% aus Additiven. Das Polymerblend der Deckschicht (A) wird aus mindestens 50 Gew.-%, bevorzugt aus mindestens 60 Gew.-%, besonders bevorzugt aus mindestens 75 Gew.-%, Ethylen-Acrylsäureester-Copolymerisat aufgebaut. Der maximale Ethylen-Acrylsäureester-Copolymergehalt des Polymerblends der Deckschicht (A) beträgt 97 Gew.-%, bevorzugt 90 Gew.-%.

Beträgt der Anteil an Ethylen-Acrylsäureester-Copolymer im Polymerblend weniger als 50 Gew.-%, so sind die Hafteigenschaften zu EVA ungenügend. Beträgt der Anteil an Ethylen-Acrylsäureester-Copolymerisat mehr als 97 Gew.-%, so ist die Haftung zur Basisschicht (B) unbefriedigend.

Unter Ethylen-Acrylsäureester-Copolymerisat ist eine Copolymerisat zu verstehen, das aus Ethylen und einem oder mehreren Acrylsäureesterbausteinen aufgebaut ist. Beispiele für geeignete Acrylsäureester sind Ethylacrylat, Ethylmethacrylat, Methylacrylat, Methylmethacrylat, Propylacrylat, Propylmethacrylat, Iso-Propylacrylat, Iso-Propylmethacrylat, N-Butylacrylat, N-Butlymethacrylat, Iso-Butylacrylat, Iso-Butlymethacrylat, Tert-Butylacrylat, Tert-Butylmethacrylat, N-Hexylacrylat, N-Hexylmethacrylat, N-Octylacrylat, N-Octylmethacrylat, 2-Octylacrylat, 2-Octylmethacrylat, Undecylacrylat, Undecylmethacrylat, Octadecylacrylat, Octadecylmethacrylat, Dodecylacrylat, Dodecylmethacrylat, 2-Ethylhexylacrylat, 2-Ethylhexylmethacrylat, Isobornylacrylat, Isobomylmethacrylat, Cyclohexylacrylat, Cyclohexylmethacrylat, 2-Hydroxyethylacrylat, 2-Hydroxyethylmethacrylat, wobei solche Copolymerisate bevorzugt sind, die Acrylsäureester enthalten, die ausgewählt sind aus Methylacrylat, Ethylacrylat, Butylacrylat, 2-Ethylhexylacrylat und deren Kombinationen; besonders bevorzugt sind Ethylen-Methacrylat und Ethylen-Butylacrylat, wobei ganz besonders bevorzugt Ethylen- Methacrylat eingesetzt wird.

Der Gehalt an Acrylsäureester im Ethylen-Acrylsäureester-Copolymer beträgt 2,5 bis 15 Mol-%, bevorzugt 3 bis 12 Mol-% und besonders bevorzugt 5 bis 11 Mol-%.

Der Schmelzindex (2,16 kg/190 °C) (gemessen nach DIN EN ISO 1133) der erfindungsgemäß eingesetzten Ethylen-Acrylsäureester-Copolymerisate liegt bevorzugt im Bereich von 0,5 bis 50 g/10 min, besonders bevorzugt im Bereich von 2 bis 35 g/10 min, ganz besonders bevorzug im Bereich von 4 bis 12 g/10 min.

Die erfindungsgemäß eingesetzten Ethylen-Acrylsäureester-Copolymerisate sind kommerziell erhältlich (z. B. die Typen Lotryl^{®} MA, Lotryl BA oder Lotryl EH der Fa. Arkema, Colombes, Frankreich, oder EMAC^{®} oder EBAC^{®} der Fa. Westlake, Houston, USA) oder lassen sich - durch dem Fachmann geläufige Polymerisationsverfahren - leicht herstellen.

Erfindungsgemäß enthält das Polymerblend der Deckschicht (A) neben dem oben näher beschriebenen Ethylen-Acrylsäureester-Copolymer ein Polyesterpolymer in einer Menge im Bereich von 3 bis 50 Gew.-%, bevorzugt 5 bis 40 Gew.-% und besonders bevorzugt 10 bis 25 Gew.-%. Liegt der Gehalt an Polyester unter 3 Gew.-%, so ist die Haftung zur Basisschicht (B) ungenügend. Liegt der Gehalt oberhalb von 50 Gew.-%, so wird die Haftung zu EVA unbefriedigend.

Für den Polyester wird bevorzugt der gleiche Polyestertyp ausgewählt wie er bereits für die Basisschicht (B) eingesetzt wird. Der Polyesteranteil in der Deckschicht (A) hat weiterhin einen günstigen Effekt auf die Herstellbarkeit der Folie. Durch die Zugabe von Polyester wird die Klebeneigung der Deckschicht (A) zu beheizten, metallischen Walzen wie sie üblicherweise im Folienherstellungsprozess eingesetzt werden verringert, was ausgesprochen wünschenswert ist.

Die Deckschicht (A) kann bis zu 25 Gew.-% an Additiven enthalten, die üblicherweise zur Modifizierung von Polyester eingesetzt werden. Bei den Additiven handelt es sich zum Beispiel um Antiblockmittel, Wachse, Stabilisatoren wie Flammschutzmittel, UV-Stabilisatoren, Hydrolysestabilisatoren, Farbstoffe oder Farbpigmente, wobei bei den Farbpigmenten besonders Weißpigmente wie BaSO₄ und TiO₂ bevorzugt werden. Der Zusatz von Wachsen zur Verringerung der Klebeneigung der Deckschicht (A) zu metallischen Walzen ist möglich. Besonders geeignet als Wachszusatz sind Amidwachse und hier besonders N,N'-ethylen-bisölsäureamid und N,N'-ethylenbisstearinsäureamid. Die Zuatzmenge an Wachs beträgt bevorzugt 0,5 bis 3 Gew.-%, insbesondere 1 bis 2 Gew.-%.

Der Zusatz von Weißpigmenten wie BaSO₄ und TiO₂ zur Deckschicht (A) ist vorteilhaft, wenn man die Reflexionseigenschaften der Folie gegenüber Licht verbessern will, um die elektrische Ausbeute des Solarmoduls zu erhöhen. Insbesondere der Zusatz von Weißpigment in Mengen von 3 bis 25 Gew.-% ist vorteilhaft, wobei mit steigendem Anteil an Weißpigment die Haftung zum EVA sinkt, daher sollte der Anteil an Weißpigment ≤20 Gew.-% betragen. Insbesondere ist der Zusatz von TiO₂ insbesondere in der Rutilmodifikation günstig, wobei besonders vorteilhaft ist, wenn das TiO₂ anorganisch und/oder organisch beschichtet ist. Der Zusatz des TiO₂ bewirkt einerseits die Weißfärbung der Folie und führt aufgrund einer erhöhten Lichtreflexion zu einer Erhöhung der elektrischen Ausbeute beim Einsatz der Folie in Backsheets von Solarmodulen und andererseits zur Verbesserung der UV-Beständigkeit der Folie bzw. des Backsheets, was beim Außeneinsatz des Solarmoduls von besonderem Vorteil ist. Die anorganische Beschichtung reduziert die katalytisch wirksame Oberfläche des TiO₂, die zu einer Vergilbung der Folie führen kann, während sich die organische Beschichtung positiv auf die Einarbeitung des TiO₂ in die Deckschichtrohstoffmischung auswirkt. Der mittlere Teilchendurchmesser d₅₀ des TiO₂ liegt bevorzugt im Bereich von 0,1 bis 0,5 µm und besonders bevorzugt bei 0,15 bis 0,3 µm. Die Zusatzmenge des TiO₂ liegt bevorzugt bei 3 bis 20 Gew.-%, besonders bevorzugt bei 4 bis 12 Gew.-% und ganz besonders bevorzugt bei 5 bis 10 Gew.-%.

Die Erfindung betrifft auch ein Verfahren zur Herstellung der erfindungsgemäßen Polyesterfolie nach dem an sich aus der Literatur bekannten Herstellungsverfahren für coextrudierte, biaxial orientierte Polyesterfolien (z. B. Kapitel "Polyesters, Films" in der "Encyclopedia of Polymer Science and Engeneering", Vol. 12, John Wiley & Sons, 1988).

Im Rahmen dieses Verfahrens wird so vorgegangen, dass die der Folie entsprechenden Schmelzen durch eine Flachdüse coextrudiert werden, die so erhaltene coextrudierte Folie zur Verfestigung auf einer oder mehreren gekühlten Walze/n angelegt wird, die Folie anschließend biaxial gestreckt (orientiert), die biaxial gestreckte Folie thermofixiert und gegebenenfalls an einer zur Behandlung vorgesehenen Oberflächenschicht noch corona- oder flammbehandelt, abgekühlt und aufgewickelt wird.

Wenn auch einer der Vorteile der vorliegenden Erfindung darin liegt, dass die EVA-Haftvermittlung nicht über eine In-line-Beschichtung erfolgt, so kann die erfindungsgemäße Folie dennoch - sofern dies aus anderen Gründen für notwendig erachtet wird - im In-line- oder Off-line-Verfahren beschichtet werden. So kann sie beispielsweise zur weiteren Modifizierung der Folieneigenschaften auf der der (A)-Schicht gegenüberliegenden Oberfläche mit einer bekannten Beschichtung (z. B. zur Verbesserung der Hafteigenschaften, was bei Laminieranwendungen vorteilhaft sein kann) versehen werden.

Zunächst wird, wie beim Extrusionsverfahren üblich, das Polymere bzw. die Polymermischung für die einzelnen Schichten der Folie jeweils in einem Extruder komprimiert und verflüssigt, wobei die gegebenenfalls als Zusätze vorgesehenen Additive bereits im Polymer bzw. in der Polymermischung enthalten sein können. Bei Einsatz von Einschneckenextrudern sollten die Rohstoffe in üblicher Weise vorgetrocknet werden, um einen unerwünschten hydrolytischen Abbau der Polyesterrohstoffe während der Extrusion zu verhindern. Bei Einsatz von so genannten Zweischneckenextrudern mit Entgasung kann in der Regel auf eine Vortrocknung verzichtet werden. Der Einsatz von Zweischneckenextrudern mit Entgasung ist daher besonders wirtschaftlicht und bevorzugt. Der Basisschicht können in diesem Fall bis zu 75 Gew.-% Eigenfolienregenerat zugesetzt werden. Die Temperaturen der Schmelzeströme werden zur Verbesserung der Hydrolyseeigenschaften der Polymere dabei so niedrig wie möglich eingestellt. Die Schmelzetemperatur der Basisschicht liegt dabei bevorzugt immer unterhalb von 305 °C und besonders bevorzugt unterhalb von 295 °C, insbesondere unterhalb von 285 °C. Die maximale Schmelzetemperatur in Extruder und Schmelzeleitung in der Extrusion der A-Schicht liegt bevorzugt unterhalb von 285 °C und besonders bevorzugt unterhalb von 275 °C und idealerweise unterhalb von 270 °C. Die Schmelzen werden vereinigt, dann gleichzeitig durch eine Flachdüse (Breitschlitzdüse) gepresst, und die ausgepresste Schmelze wird auf einer oder mehreren gekühlten Abzugswalzen angelegt, wobei die Schmelze abkühlt und sich zu einer Vorfolie verfestigt.

Die biaxiale Streckung (Orientierung) kann simultan, z. B. unter Einsatz eines Simultanstreckrahmens, oder sequenziell, z. B. mit Hilfe des Sequenziellstreckverfahrens, erfolgen. Das Simultanstreckverfahren bietet den Vorteil, dass es kontaktlos erfolgt, was Vorteile beim Verstrecken von Folien mit klebrigen Oberflächenschichten hat. Verfahrensbedingungen zur Herstellung simultan verstreckten Polyesterfolien werden z. B. in EP-A-1 207 035, EP-A-1 529 799 oder US-A-6,685,865 angegeben.

Die Temperatur, bei der die Simultanverstreckung durchgeführt werden kann, kann in weiten Bereichen variiert werden. Im Allgemeinen ist der Temperaturbereich von 70 bis 140 °C bevorzugt, wobei der Streckgrad in Maschinenrichtung im Bereich von 2,0 bis 5,5:1, bevorzugt 3 bis 4:1, liegt und der Streckgrad quer zur Maschinenrichtung bevorzugt im Bereich von 2,5 bis 5:1, bevorzugt 3 bis 4,5:1, liegt.

Bei der sequenziellen Streckung wird die Vorfolie vorzugsweise zuerst in Längsrichtung (d. h. in Maschinenrichtung = MD-Richtung) und anschließend in Querrichtung (d. h. senkrecht zur Maschinenrichtung = TD-Richtung) gestreckt. Das Strecken in Längsrichtung lässt sich mit Hilfe zweier entsprechend dem angestrebten Streckverhältnis verschieden schnell rotierender Walzen durchführen. Vorteilhaft wird die Folienbahn in der Längsstreckung so geführt, dass die der (A)-Schicht abgewandte Oberfläche der Folie mit den Oberflächen der unterschiedlich schnell rotierenden Streckwalzen in Kontakt steht. Noch vorteilhafter für die Längsstreckung der erfindungsgemäßen Folien ist es, wenn diese mittels Tangentialstreckung erfolgt, die z. B. im Kapitel "Polyesters, Films" in der "Encyclopedia of Polymer Science and Engeneering" (Vol. 12, John Wiley & Sons, 1988) beschrieben ist. Dabei wird die Folienführung so gewählt, dass die Oberfläche der Deckschicht (A) nicht in Kontakt mit der langsam und schnelllaufenden Streckwalze steht, hierdurch kann ein eventuelles Kleben der Folie an den Streckwalzen vermieden werden.

Zum Querstrecken benutzt man bei der sequenziellen Streckung allgemein einen entsprechenden Kluppenrahmen, in dem die Folie an beiden Rändern eingespannt, vorgeheizt und dann bei erhöhter Temperatur nach beiden Seiten verstreckt wird.

Die Temperaturen, bei der die sequenzielle biaxiale Streckung durchgeführt wird, richten sich bei der Längsstreckung insbesondere nach den Klebeeigenschaften der Deckschicht (A). Erfindungsgemäß wird die Längsstreckung bevorzugt bei einer Temperatur in einem Bereich von 70 bis 95 °C durchgeführt, wobei die Aufheiztemperaturen im Bereich von 70 bis 95 °C (bevorzugt unterhalb von 90 °C) und die Strecktemperaturen im Bereich von 75 bis 95 °C liegen. Die Temperatur, bei der die Streckung in Querrichtung durchgeführt wird, kann in einem relativ großen Bereich variieren und richtet sich nach den gewünschten Eigenschaften der Folie und liegt bevorzugt im Bereich von 90 bis 135 °C. Das Längsstreckverhältnis liegt allgemein im Bereich von 2,0:1 bis 4,5:1, bevorzugt von 2,1:1 bis 4,0:1 und besonders bevorzugt von 2,2:1 bis 3,6:1. Das Querstreckverhältnis liegt allgemein im Bereich von 3,0:1 bis 5,0:1, bevorzugt von 3,5:1 1 bis 4,5:1.

Bei der nachfolgenden Thermofixierung, die sich der simultanen wie der sequenziellen Streckung anschließt, wird die Folie über eine Zeitdauer von etwa 0,1 bis 10 s bei einer Temperatur im Bereich von 150 bis 250 °C gehalten. Die Maximaltemperatur liegt dabei bevorzugt bei >210 °C, besonders bevorzugt bei >230 °C und besonders bevorzugt bei > 240 °C. Anschließend wird die Folie in üblicher Weise abgekühlt und zu einer Folienrolle aufgewickelt.

Da das Rückseitenlaminat in einem thermischen Laminierschritt aufgebracht wird, hat es sich als günstig erwiesen, wenn der Schrumpf der Folie in Längs- und Querrichtung (gemessen bei 150 °C, 30 min) bei kleiner 2,5 % und besonders bei kleiner 2 % und insbesondere bei <1,8 % liegt. Der Querschrumpf ist dabei von besonderer Bedeutung und liegt daher bevorzugt bei kleiner 1,2 %. Neben den erwähnten hohen Maximaltemperaturen in der Thermofixierung hat es sich dabei als günstig erwiesen, wenn die Folie in der Fixierung um mindestens 1 %, bevorzugt um mindestens 3 %, relaxiert wird. In einem Simultanrahmen findet diese Relaxation bevorzugt in Längs- und Querrichtung statt und in einem sequenziellen Verfahren bevorzugt nur in Querrichtung. Bevorzugt wird mindestens 50 % der Gesamtrelaxation bei einer Temperatur unterhalb von 200 °C eingestellt.

Die Gesamtfoliendicke sowie die individuellen Dicken der Basisschicht (B) und der coextrudierten Deckschicht (A) können in weiten Grenzen variiert werden. Die Gesamtfoliendicke liegt bevorzugt im Bereich von 10 bis 600 µm, insbesondere im Bereich von 12 bis 400 µm und besonders bevorzugt im Bereich von 18 bis 300 µm, wobei die minimale Dicke der Deckschicht (A) größer/gleich 0,5 µm ist, da ansonsten die Hafteigenschaften der Deckschicht (A) gegenüber dem Einkapselungsmaterial der Solarzellen ungenügend ist. Deckschichtdicken der coextrudierten Deckschicht (A) von mehr als 6 µm führen zu keiner weiteren Verbesserung der Hafteigenschaften. Bevorzug liegt die Deckschichtdicke der coextrudierten Schicht (A) im Bereich von 0,5 bis 20 µm, insbesondere im Bereich von 2 bis 6 µm.

Die erfindungsgemäße Folie eignet sich hervorragend als Backsheet bzw. Backsheetbestandteil für Solarmodule. Die erfindungsgemäße Folie kann alleine als Backsheet für ein Solarmodul eingesetzt werden. Sie kann aber auch als Bestandteil eines Backsheets für Solarmodule eingesetzt werden. Wird die erfindungsgemäße Folie als Bestandteil eines laminierten Backsheets für Solarmodule eingesetzt, so kann sie mit weiteren Folien zusammenlaminiert werden, wobei das laminierte Backsheet so aufgebaut ist, dass die Deckschicht (A) der erfindungsgemäßen Folie im fertigen Modul die EVA-Einbettungsschicht kontaktiert. Das Backsheetlaminat kann aus mehreren Folienlagen bzw. Schichten aufgebaut sein, die insbesondere auch Wasserdampfbarriereschichten (Al-Folien, Albedampfte Polyesterfolien, SiOₓ oder AlOₓ oder entsprechend kombinierte Schichten) umfassen. In den die erfindungsgemäße Folie umfassenden Backsheetlaminaten können die üblicherweise in solchen Laminaten eingesetzten Folien wie z. B. aus PVF oder anderen fluorhaltige Folienmaterialien, PET, PEN eingesetzt werden. Barriereschichten gegen Wasserdampf wirken sich positiv auf die elektrische Langzeitausbeute des Solarmoduls aus.

In einer besonders bevorzugten Backsheetlaminatausführungsform besteht das Backsheet ausschließlich aus der erfindungsgemäßen Polyesterfolie. Diese Ausführungsform hat gegenüber fluorhaltigen Backsheets den Vorteil, dass es problemlos recycelt oder verbrannt werden kann.

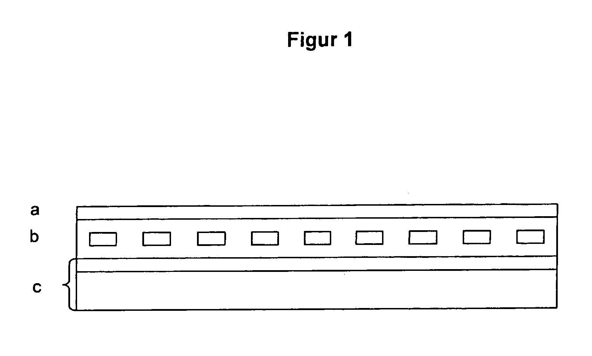

Figur 1 erläutert den Aufbau eines Solarmoduls unter Verwendung der erfindungsgemäßen Folie beispielhaft, wobei a) eine hochtransparente Glasfront, b) in vernetzem EVA eingebettete Si-Solarzellen und c) das Backsheet, d. h. die erfindungsgemäße Folie, darstellen.

Zur Charakterisierung der Rohstoffe und der Folien wurden im Rahmen der vorliegenden Erfindung die folgenden Messmethoden benutzt:

### Messung des mittleren Durchmessers d₅₀

Die Bestimmung des mittleren Durchmessers d₅₀ teilchenförmiger Additive wird mittels Laser auf einem Malvern Master Sizer mittels Laserscannung durchgerührt (andere Messgeräte sind z. B. Horiba LA 500 oder Sympathec Helos, welche das gleiche Messprinzip verwenden). Die Proben werden dazu in eine Küvette mit Wasser gegeben und diese dann in das Messgerät gestellt. Mittels Laser wird die Dispersion abgerastert und aus dem Signal durch Vergleich mit einer Eichkurve die Partikelgrößenverteilung bestimmt. Der Messvorgang ist automatisch und beinhaltet auch die mathematische Bestimmung des d₅₀-Wertes. Der d₅₀-Wert wird dabei definitionsgemäß aus der (relativen) Summenkurve der Partikelgrößenverteilung bestimmt: Der Schnittpunkt des 50%-Ordinatenwertes mit der Summenkurve liefert auf der Abszissenachse den gewünschten d₅₀-Wert (auch Median genannt).

### IV-Wert

Der IV-Wert des Polyethylenterephthalats wird durch Viskositätsmessung bei 25 °C von verdünnten o-Chlorbenzollösungen und Extrapolation auf c = 0 bestimmt. Weitere Angaben zur IV-Bestimmungstechnik sind in Encyclopedia of Polymer Science and Engineering, 1988, Vol. 11, S. 322-323, und Kirk-Othmer, Encyclopedia of Chemical Technology, 4th Edition, Vol. 21, 1997, S. 356-358, zu finden.

### Gelbzahl (yellowness index)

Die Gelbzahl wird gemäß ASTM D1925-70 bestimmt.

### Bestimmung der Haftfestigkeit zu EVA und der Alterungsbeständigkeit der Haftfestigkeit zu EVA

Die Bestimmung und Beurteilung der Haftfestigkeit erfolgt wie in EP-A-1 826 826 beschrieben. Allerdings wird statt Solar EVA^{®} SC4 der Typ Solar EVA SC50B der Nachfolgegesellschaft Mitsui Chemical Fabro Inc. (JP) als EVA-Folie benutzt.

| | |
|---|---|
| 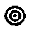 : | 20 N/20 mm oder mehr - Haftfestigkeit ist sehr gut |
| ○ : | 10 N/20 mm bis weniger als 20 N/20 mm - Haftfestigkeit ist gut |
| Δ : | 5 N/20 mm bis weniger als 10 N/20 mm - Haftfestigkeit ist mäßig |
| × : | weniger als 5 N/20 mm - Haftfestigkeit ist schlecht |

Zusätzlich zu der Alterung nach 1000 h bei 85 °C/85 % rel. hum. wird auch die Haftfestigkeit nach 2000 h bei 85 °C/85 % rel. hum. bewertet, da 1000 h nicht die volle Lebensdauer der Module simuliert und daher auch nach der doppelten Zeit noch eine ausreichende Haftfestigkeit vorhanden sein muss.

| | |
|---|---|
| 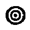 : | Erhalt der Haftfestigkeit von 75 % oder mehr - Beständigkeit der Haftfestigkeit sehr gut |
| ○ : | Erhalt der Haftfestigkeit von 50 % oder weniger als 75 % - Beständigkeit der Haftfestigkeit gut |
| Δ : | Erhalt der Haftfestigkeit von 25 % oder weniger als 50 % - Beständigkeit der Haftfestigkeit mäßig |
| × : | Erhalt der Haftfestigkeit von weniger als 25 % - Beständigkeit der Haftfestigkeit ist schlecht |

### Bewitterungsbeständigkeit

Die Bestimmung und Beurteilung der der Bewitterungsresistenz erfolgt wie in EP-A- 1 826 826 beschrieben.

| | |
|---|---|
| 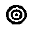 : | Erhalt der Haftfestigkeit von 75 % oder mehr - Bewitterungsbeständigkeit der Haftfestigkeit sehr gut |
| ○ : | Erhalt der Haftfestigkeit von 50 % oder weniger als 75 % - Bewitterungsbeständigkeit der Haftfestigkeit gut |
| Δ : | Erhalt der Haftfestigkeit von 25 % oder weniger als 50 % - Bewitterungsbeständigkeit der Haftfestigkeit mäßig |
| × : | Erhalt der Haftfestigkeit von weniger als 25 % - Bewitterungsbeständigkeit der Haftfestigkeit ist schlecht |

### Schrumpf

Der Schrumpf wird gemäß DIN 40634 bei 150 °C und 15 min Verweildauer gemessen.

Die Erfindung wird anhand der nachfolgenden Beispiele und Vergleichsbeispiele näher erläutert.

### Beispiel 1

| | | |
|---|---|---|
| 96 Gew.-% Granulat | aus Polyethylenterephthalat (Typ 8610, Hersteller Invista, USA, festphasenkondensiert bis IV = 0,68, CEG: 10 mmol/kg) und | |
| 4 Gew.-% | Polyestergranulat | |
| | (0,5 Gew.-% | SiO₂, Sylysia^{®} 320, Hersteller Fuji Sylysia, JP, d₅₀ = 2,5 µm, und |
| | 60 Gew.-% | TiO₂ Ti-Pure^{®} R-104, Hersteller DuPont, USA, eingeknetet in einem Zweischneckenextruder in |
| | 39,5 Gew.-% | Polyestergranulat Typ 8610) |

wurden einem Zweischneckenextruder mit Entgasung für die Basisschicht (B) zugeführt. Ebenfalls wurden ein Gemisch aus

| | |
|---|---|
| 12 Gew.-% | Polyethylenterephthalat (Typ 8610, festphasenkondensiert, IV = 0,68) und |
| 88 Gew.% | Ethylen-Methacrylat-Copolymer (Lotryl 24 MA 07) |

einem Zweischneckenextruder mit Entgasung für die Deckschicht (A) zugeführt. Der Gehalt an Methacrylat im eingesetzten Ethylen-Methacrylat-Copolymer betrug 9,4 Mol-%, was etwa 24 Gew.-%, bezogen auf das Copolymerisat, entspricht. Der Schmelzindex MFI (2,16 kg/190 °C) betrug 7 g/10 min. Die Rohstoffe wurden jeweils in den Zweischneckenextrudern aufgeschmolzen, homogenisiert und entgast. Die Temperatur in Extruderausgang und Schmelzeleitung der Basisschicht wurde dabei auf 284 °C eingestellt, und die Temperatur in Extruderausgang und Schmelzeleitung für die Deckschicht (A) wurde auf 265 °C eingestellt. Dann wurden die beiden Schmelzeströme durch Coextrusion in einer Zweischichtdüse übereinander geschichtet und über eine Düsenlippe ausgestoßen. Der resultierende Schmelzefilm wurde auf einer gekühlten Gießwalze (Kühlwalzentemperatur 30 °C) angelegt und abgekühlt. Die Anlegung erfolgte in der Weise, dass die freie Oberfläche der (B)-Schicht in Kontakt mit der Kühlwalze gebracht wurde. Nach einer simultanen Verstreckung der Vorfolie (Strecktemperatur 106 °C, Längsstreckverhältnis 3,6, Querstreckverhältnis 3,8) und anschließender Thermofixierung (242 °C Maximaltemperatur, 1 s) wurde eine zweischichtige biaxial orientierte Folie mit AB-Aufbau erhalten. Nach der heißesten Zone der Thermofixierung wurde bei einer Temperatur von 185 °C um 3,5 % in Querrichtung und 2 % in Längsrichtung relaxiert. Die Gesamtdicke der Folie betrug 200 µm, wobei die (A)-Schicht eine Dicke von 6 µm aufwies. Weitere Folieneigenschaften und Testergebnisse können der Tabelle "Ergebnisse" entnommen werden.

### Beispiel 2

Es wurde analog Beispiel 1 vorgegangen, wobei in die Basisschicht

| | | |
|---|---|---|
| 3 Gew.-% | epoxidiertes Leinöl (Vikoflex^{®} 9010, Hersteller Arkema, USA), | |
| 1 Gew.-% | Hexylethylester der epoxidierten Leinölfettsäuren (Vikoflex 9080), | |
| 92 Gew.-% | Granulat aus Polyethylenterephthalat (Typ 8610, Hersteller Invista, USA, festphasenkondensiert bis IV = 0,68, CEG: 10 mmol/kg) und | |
| 4 Gew.-% | Polyestergranulat | |
| | (0,5 Gew.-% | SiO₂, Sylysia 320, Hersteller Fuji Sylysia, JP, d₅₀ = 2,5 µm, und |
| | 60 Gew.% | TiO₂, Ti-Pure® R-104, Hersteller DuPont, USA, eingeknetet in einem Zweischneckenextruder in |
| | 39,5 Gew.-% | Polyestergranulat Typ 8610) |

dosiert wurden.

### Beispiel 3

Es wurde analog Beispiel 1 vorgegangen, wobei der Basisschicht 35 Gew.-% Eigenregenerat hinzugefügt wurden. Neben dem Eigenregenerat wurden

| | | |
|---|---|---|
| 61 Gew.-% | Granulat aus Polyethylenterephthalat (Typ 8610, Hersteller Invista, USA, festphasenkondensiert bis IV = 0,68, CEG: 10 mmol/kg) und | |
| 4 Gew.-% | Polyestergranulat | |
| | (0,5 Gew.-% | SiO₂, Sylysia 320, Hersteller Fuji Sylysia, JP, d₅₀ = 2,5 µm, und |
| | 60 Gew.-% | TiO₂ Ti-Pure^{®} R-104, Hersteller DuPont, USA, eingeknetet in einem Zweischneckenextruder in |
| | 39,5 Gew.-% | Polyestergranulat Typ 8610) |

zudosiert.

### Beispiel 4

Es wurde analog Beispiel 1 vorgegangen, wobei in der Basisschicht die 96 Gew.-% festphasenkondensiertes Polyethylenterephthalat (Typ 8610, s. o.) durch dieselbe Menge Polyestergranulat Typ SB62F0 (Advansa, TR) ersetzt wurden.

### Beispiel 5

| | | |
|---|---|---|
| 96 Gew.-% Granulat | aus Polyethylenterephthalat (Typ 8610, Hersteller Invista, USA, festphasenkondensiert bis IV = 0,68, CEG: 10 mmol/kg) und | |
| 4 Gew.-% | Polyestergranulat | |
| | (0,5 Gew.-% | SiO₂ Sylysia 320, Hersteller Fuji Sylysia, JP, d₅₀ = 2,5 µm und |
| | 60 Gew.-% | TiO₂ Ti-Pure^{®} R-104, Hersteller DuPont, USA, eingeknetet in einem Zweischneckenextruder in |
| | 39,5 Gew.-% | Polyestergranulat Typ 8610) |

wurden einem Zweischneckenextruder mit Entgasung für die Basisschicht (B) zugeführt. Ebenfalls wurden ein Gemisch aus

| | |
|---|---|
| 12 Gew.-% | Polyethylenterephthalat (Typ 8610, festphasenkondensiert, IV = 0,68) und |
| 88 Gew.% | Ethylen-Methacrylat-Copolymer (Lotryl 24 MA 07) |

einem Zweischneckenextruder mit Entgasung für die Deckschicht (A) zugeführt. Der Gehalt an Methacrylat im eingesetzten Ethylen-Methacrylat-Copolymer betrug 9,4 Mol-%, was etwa 24 Gew.%, bezogen auf das Copolymerisat, entspricht. Der Schmelzindex MFI (2,16 kg/190 °C) betrug 7 g/10 min. Die Rohstoffe wurden jeweils in den Zweischneckenextrudern aufgeschmolzen, homogenisiert und entgast. Die Temperatur in Extruderausgang und Schmelzeleitung der Basisschicht wurde dabei auf 284 °C eingestellt, und die Temperatur in Extruderausgang und Schmelzeleitung für die Deckschicht (A) wurde auf 265 °C eingestellt. Dann wurden die beiden Schmelzeströme durch Coextrusion in einer Zweischichtdüse übereinander geschichtet und über eine Düsenlippe ausgestoßen. Der resultierende Schmelzefilm wurde auf einer gekühlten Gießwalze (Kühlwalzentemperatur 30 °C) angelegt und abgekühlt. Die Anlegung erfolgte in der Weise, dass die freie Oberfläche der (B)-Schicht in Kontakt mit der Kühlwalze gebracht wurde. Nach einer simultanen Verstreckung der Vorfolie (Strecktemperatur 106 °C, Längsstreckverhältnis 3,6, Querstreckverhältnis 3,8) und anschließender Thermofixierung (242 °C Maximaltemperatur, 1 s) wurde eine zweischichtige biaxial orientierte Folie mit AB-Aufbau erhalten. Nach der heißesten Zone der Thermofixierung wurde bei einer Temperatur von 185 °C um 3,5 % in Querrrichtung und 2 % in Längsrichtung relaxiert. Die Gesamtdicke der Folie betrug 50 µm, wobei die (A)-Schicht eine Dicke von 4 µm aufwies. Weitere Folieneigenschaften und Testergebnisse können der Tabelle "Ergebnisse" entnommen werden.

### Beispiel 6

Es wurde analog Beispiel 5 vorgegangen, wobei in die Basisschicht

| | | |
|---|---|---|
| 3 Gew.-% | epoxidiertes Leinöl (Vikoflex 9010, Arkema, USA), | |
| 1 Gew.-% | Hexylethylester der epoxidierten Leinölfettsäuren (Vikoflex 9080), | |
| 92 Gew.-% | Granulat aus Polyethylenterephthalat (Typ 8610, Hersteller Invista, USA, festphasenkondensiert bis IV = 0,68, CEG: 10 mmol/kg) und | |
| 4 Gew.-% | Polyestergranulat | |
| | (0,5 Gew.-% | SiO₂, Sylysia 320, Hersteller Fuji Sylysia, JP, d₅₀ = 2,5 µm, und |
| | 60 Gew.-% | TiO₂ Ti-Pure R-104, Hersteller DuPont, USA, eingeknetet in einem Zweischneckenextruder in |
| | 39,5 Gew.-% | Polyestergranulat Typ 8610) |

dosiert wurden.

### Beispiel 7

Es wurde analog Beispiel 5 vorgegangen, wobei der Basisschicht 35 Gew.-% Eigenregenerat hinzugefügt wurden. Neben dem Eigenregenerat wurden

| | | |
|---|---|---|
| 61 Gew.-% | Granulat aus Polyethylenterephthalat (Typ 8610, Hersteller Invista, USA, festphasenkondensiert bis IV = 0,68, CEG: 10 mmol/kg) und | |
| 4 Gew.-% | Polyestergranulat | |
| | (0,5 Gew.-% | SiO₂ Sylysia 320, Hersteller Fuji Sylysia, JP, d₅₀ = 2,5 µm, und |
| | 60 Gew.-% | TiO₂, Ti-Pure R-104, Hersteller DuPont, USA, |
| | | eingeknetet in einem Zweischneckenextruder in |
| | 39,5 Gew.-% | Polyestergranulat Typ 8610) |

zudosiert.

### Beispiel 8

Es wurde analog Beispiel 5 vorgegangen, wobei in der Basisschicht die 96 Gew.-% festphasenkondensiertes Polyethylenterephthalat (Typ 8610) durch dieselbe Menge Polyestergranulat Typ SB62F0 (Advansa, TR) ersetzt wurden.

### Vergleichsbeispiel 1

Beispiel 1 aus EP-A-1 826 826 wurde wiederholt.

### Vergleichsbeispiel 2

Beispiel 1 aus EP-A-1 826 826 wurde wiederholt, wobei allerdings 35 Gew.-% des eingesetzten Polyesters durch 35 Gew.-% Folieneigenregenerat ersetzt wurden.

**Tab. 1: Ergebnisse der Charakterisierung der Beispiele und Vergleichsbeispiele**

| | Adhäsion zu EVA | Alterungsbeständigkeit der Adhäsion zu EVA | | Bewitterungsbeständigkeit | Gelbfärbung | Schrumpf | |
|---|---|---|---|---|---|---|---|
| | | 1000 h | 2000 h | | | MD | TD |
| Beispiel 1 | 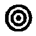 | 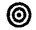 | 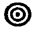 | 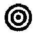 | A | 0,6 | 0,0 |
| Beispiel 2 | 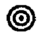 | 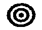 | 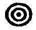 | 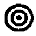 | A | 0,7 | 0,0 |
| Beispiel 3 | 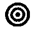 | 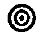 | 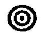 | 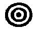 | B | 0,5 | 0,1 |
| Beispiel 4 | 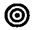 | 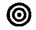 | 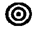 | 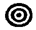 | A | 0,6 | 0,2 |
| Beispiel 5 | 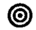 | 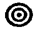 | 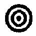 | 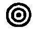 | A | 0,5 | 0,0 |
| Beispiel 6 | 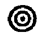 | 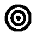 | 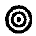 | 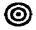 | A | 0,6 | 0,1 |
| Beispiel 7 | 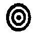 | 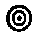 | 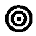 | 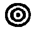 | B | 0,6 | 0,0 |
| Beispiel 8 | 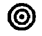 | 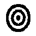 | 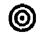 | 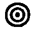 | A | 0,7 | 0,2 |
| Vergleichsbeispiel 1 (Beispiel 1 aus EP 1826 826 A1) | 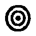 | 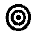 | ○ | ○ | A | Nicht bestimmt | n.b. |
| Vergleichsbeispiel 2 (Beispiel 1 aus EP 1 826 826 A1, aber mit 35 Gew.-% Eigenregenerat) | 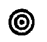 | 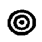 | ○ | ○ | C | n.b. | n.b. |

Die Gelbfärbung wurde visuell beurteilt und in die Klassen A = keine Gelbfärbung erkennbar, B = Gelbfärbung erkennbar und C = deutlich Gelbfärbung unterteilt.

Die erfindungsgemäßen Folien zeigen eine sehr gute Haftung, Alterungsbeständigkeit der Haftfestigkeit, Bewitterungsbeständigkeit, niedrige Gelbzahlen und niedrigen Schrumpf und eignen sich hervorragend für Backsheets und Backsheetlaminate.

## Patentansprüche

1. Coextrudierte, biaxial orientierte Polyesterfolie, umfassend eine Basisschicht (B) und mindestens eine Deckschicht (A), wobei
(a) die Basisschicht (B) überwiegend aus thermoplastischem Polyester besteht und
(b) die Deckschicht (A) überwiegend aus einer Mischung von
50 bis 97 Gew.-% Ethylen-Acrylsäureester-Copolymer und
3 bis 50 Gew.-% Polyesterpolymer besteht,
wobei der Anteil an Acrylsäureester im Ethylen-Acrylsäureester-Copolymer 2,5 bis 15 Mol-% beträgt, bezogen auf die Monomeren des Copolymers.

2. Polyesterfolie nach Anspruch 1, **dadurch gekennzeichnet, dass** die Basisschicht (B) zu mindestens 65 Gew.-% aus thermoplastischem Polyester besteht.

3. Polyesterfolie nach Anspruch 1 oder 2, **dadurch gekennzeichnet, dass** die Basisschicht (B) bis zu 35 Gew.-% (bezogen auf das Gewicht der Basisschicht (B)) an üblichen Additiven enthält.

4. Polyesterfolie nach Anspruch 3, **dadurch gekennzeichnet, dass** das übliche Additiv ein Hydrolyseschutzmittel ist.

5. Polyesterfolie nach einem der Ansprüche 1 bis 4, **dadurch gekennzeichnet, dass** der thermoplastische Polyester der Basisschicht (B) ein Polyester mit niedrigem Carboxylendgruppengehalt ist.

6. Polyesterfolie nach einem der Ansprüche 1 bis 5, **dadurch gekennzeichnet, dass** der thermoplastische Polyester der Basisschicht (B) bis zu 25 Gew.-% Ethylen-Acrylsäureester-Copolymerisat enthält.

7. Polyesterfolie nach einem der Ansprüche 1 bis 6, **dadurch gekennzeichnet, dass** die Deckschicht (A) mindestens 75 Gew.-% der Mischung aus Ethylen-Acrylsäureester-Copolymerisat und Polyesterpolymer enthält.

8. Polyesterfolie nach einem der Ansprüche 1 bis 7, **dadurch gekennzeichnet, dass** das Ethylen-Acrylsäureester-Copolymerisat ein Copolymerisat aus Ethylen und einer oder mehreren Acrylsäureestern ist.

9. Polyesterfolie nach Anspruch 8, **dadurch gekennzeichnet, dass** der Acrylsäureester ausgewählt ist aus der Gruppe der Verbindungen, bestehend aus: Ethylacrylat, Ethylmethacrylat, Methylacrylat, Methylmethacrylat, Propylacrylat, Propylmethacrylat, Iso-Propylacrylat, Iso-Propylmethacrylat, N-Butylacrylat, N-Butlymethacrylat, Iso-Butylacrylat, Iso-Butlymethacrylat, Tert-Butylacrylat, Tert-Butylmethacrylat, N-Hexylacrylat, N-Hexylmethacrylat, N-Octylacrylat, N-Octylmethacrylat, 2-Octylacrylat, 2-Octylmethacrylat, Undecylacrylat, Undecylmethacrylat, Octadecylacrylat, Octadecylmethacrylat, Dodecylacrylat, Dodecylmethacrylat, 2-Ethylhexylacrylat, 2-Ethylhexylmethacrylat, Isobornylacrylat, Isobomylmethacrylat, Cyclohexylacrylat, Cyclohexylmethacrylat, 2-Hydroxyethylacrylat, 2-Hydroxyethylmethacrylat.

10. Polyesterfolie nach einem der Ansprüche 1 bis 9, **dadurch gekennzeichnet, dass** der Schmelzindex (2,16 kg/190 °C) (gemessen nach DIN EN ISO 1133) der Ethylen-Acrylsäureester-Copolymerisate im Bereich von 0,5 bis 50 g/10 min liegt.

11. Polyesterfolie nach einem der Ansprüche 1 bis 10, **dadurch gekennzeichnet, dass** die Deckschicht (A) bis zu 25 Gew.-% an Additiven enthält.

12. Verfahren zur Herstellung einer Polyesterfolie nach Anspruch 1, wobei die der Folie entsprechenden Schmelzen durch eine Flachdüse coextrudiert werden, die so erhaltene coextrudierte Folie zur Verfestigung auf einer oder mehreren gekühltenWalze/n angelegt wird, die Folie anschließend biaxial gestreckt (orientiert), die biaxial gestreckte Folie thermofixiert und gegebenenfalls an einer zur Behandlung vorgesehenen Oberflächenschicht corona- oder flammbehandelt, abgekühlt und aufgewickelt wird.

13. Verwendung einer Folie nach Anspruch 1 als Backsheet für ein Solarmodul.

14. Folienlaminat beinhaltend mindestens eine Folie nach Anspruch 1 sowie mindestens eine weitere Folie, die von der nach Anspruch 1 verschieden ist.

15. Solarmodul beinhaltend eine Folie nach Anspruch 1.

## Claims

1. A coextruded, biaxially oriented polyester film, encompassing a base layer (B) and at least one outer layer (A), where
(a) the base layer (B) is mainly composed of thermoplastic polyester, and
(b) the outer layer (A) is mainly composed of a mixture of
from 50 to 97 % by weight of ethylene-acrylate copolymer and
from 3 to 50 % by weight of polyester,
where the proportion of acrylate in the ethylene-acrylate copolymer is from 2.5 to 15 mol%, based on the monomers of the copolymer.

2. The polyester film as claimed in claim 1, wherein the base layer (B) is composed of at least 65 % by weight of thermoplastic polyester.

3. The polyester film as claimed in claim 1 or 2, wherein the base layer (B) comprises up to 35 % by weight (based on the weight of the base layer (B)) of conventional additives.

4. The polyester film as claimed in claim 3, wherein the conventional additive is a hydrolysis stabilizer.

5. The polyester film as claimed in any of claims 1 to 4, wherein the thermoplastic polyester of the base layer (B) is a polyester having low carboxy end group content.

6. The polyester film as claimed in any of claims 1 to 5, wherein the thermoplastic polyester of the base layer (B) comprises up to 25 % by weight of ethylene-acrylate copolymer.

7. The polyester film as claimed in any of claims 1 to 6, wherein the outer layer (A) comprises at least 75 % by weight of the mixture composed of ethylene-acrylate copolymer and polyester.

8. The polyester film as claimed in any of claims 1 to 7, wherein the ethylene-acrylate copolymer is a copolymer composed of ethylene and of one or more acrylates.

9. The polyester film as claimed in claim 8, wherein the acrylate has been selected from the group of compounds consisting of: ethyl acrylate, ethyl methacrylate, methyl acrylate, methyl methacrylate, propyl acrylate, propyl methacrylate, isopropyl acrylate, isopropyl methacrylate, n-butyl acrylate, n-butyl methacrylate, isobutyl acrylate, isobutyl methacrylate, tert-butyl acrylate, tert-butyl methacrylate, n-hexyl acrylate, n-hexyl methacrylate, n-octyl acrylate, n-octyl methacrylate, 2-octyl acrylate, 2-octyl methacrylate, undecyl acrylate, undecyl methacrylate, octadecyl acrylate, octadecyl methacrylate, dodecyl acrylate, dodecyl methacrylate, 2-ethylhexyl acrylate, 2-ethylhexyl methacrylate, isobornyl acrylate, isobornyl methacrylate, cyclohexyl acrylate, cyclohexyl methacrylate, 2-hydroxyethyl acrylate, 2-hydroxyethyl methacrylate.

10. The polyester film as claimed in any of claims 1 to 9, wherein the melt index (2.16 kg/190 °C) of the ethylene-acrylate copolymers (measured to DIN EN ISO 1133) is in the range from 0.5 to 50 g/10 min.

11. The polyester film as claimed in any of claims 1 to 10, wherein the outer layer (A) comprises up to 25 % by weight of additives.

12. A process for the production of a polyester film as claimed in claim 1, where the melts corresponding to the film are coextruded through a flat-film die, the resultant coextruded film is applied to one or more cooled rolls, the film is then biaxially stretched (oriented), and the biaxially stretched film is heat-set and, if appropriate, corona- or flame-treated on a surface layer intended for treatment, and is cooled and wound up.

13. The use of a film as claimed in claim 1 as backsheet for a solar module.

14. A film laminate including at least one film as claimed in claim 1 and also at least one further film that differs from the film as claimed in claim 1.

15. A solar module including a film as claimed in claim 1.

## Revendications

1. Feuille de polyester coextrudée, orientée biaxialement, comprenant une couche de base (B) et au moins une couche de recouvrement (A), dans laquelle
(a) la couche de base (B) est constituée dans une large mesure de polyester thermoplastique et
(b) la couche de recouvrement (A) est constituée dans une large mesure d'un mélange de
50 à 97 % en poids d'un copolymère d'éthylène-ester d'acide acrylique et de
3 à 50 % en poids d'un polymère de polyester,
dans laquelle la proportion d'ester d'acide acrylique dans le copolymère d'éthylène-ester d'acide acrylique est de 2,5 à 15 % en mole par rapport aux monomères du copolymère.

2. Feuille de polyester selon la revendication 1, **caractérisée en ce que** la couche de base (B) est constituée à hauteur d'au moins 65 % en poids d'un polyester thermoplastique.

3. Feuille de polyester selon la revendication 1 ou 2, **caractérisée en ce que** la couche de base (B) contient jusqu'à 35 % en poids (par rapport au poids de la couche de base (B)) d'additifs habituels.

4. Feuille de polyester selon la revendication 3, **caractérisée en ce que** l'additif habituel est un agent de protection contre l'hydrolyse.

5. Feuille de polyester selon l'une quelconque des revendications 1 à 4, **caractérisée en ce que** le polyester thermoplastique de la couche de base (B) est un polyester ayant une faible teneur en groupements carboxyle.

6. Feuille de polyester selon l'une quelconque des revendications 1 à 5, **caractérisée en ce que** le polyester thermoplastique de la couche de base (B) contient jusqu'à 25 % en poids d'un copolymère d'éthylène-ester d'acide acrylique.

7. Feuille de polyester selon l'une quelconque des revendications 1 à 6, **caractérisée en ce que** la couche de recouvrement (A) contient au moins 75 % en poids du mélange constitué d'un copolymère d'éthylène-ester d'acide acrylique et d'un polymère de polyester.

8. Feuille de polyester selon l'une quelconque des revendications 1 à 7, **caractérisée en ce que** le copolymère d'éthylène-ester d'acide acrylique est un copolymère d'éthylène et d'un ou de plusieurs esters d'acide acrylique.

9. Feuille de polyester selon la revendication 8, **caractérisée en ce que** l'ester d'acide acrylique est choisi dans le groupe constitué de l'acrylate d'éthyle, du méthacrylate d'éthyle, de l'acrylate de méthyle, du méthacrylate de méthyle, de l'acrylate de propyle, du méthacrylate de propyle, de l'acrylate d'iso-propyle, du méthacrylate d'iso-propyle, de l'acrylate de N-butyle, du méthacrylate de N-butyle, de l'acrylate d'iso-butyle, du méthacrylate d'iso-butyle, de l'acrylate de tert-butyle, du méthacrylate de tert-butyle, de l'acrylate de N-hexyle, du méthacrylate de N-hexyle, de l'acrylate de N-octyle, du méthacrylate de N-octyle, de l'acrylate de 2-octyle, du méthacrylate de 2-octyle, de l'acrylate de undécyle, du méthacrylate de undécyle, de l'acrylate d'octadécyle, du méthacrylate d'octadécyle, de l'acrylate de dodécyle, du méthacrylate de dodécyle, de l'acrylate de 2-éthylhexyle, du méthacrylate de 2-éthylhexyle, de l'acrylate d'isobornyle, du méthacrylate d'isobornyle, del'acrylate de cyclohexyle, du méthacrylate de cyclohexyle, de l'acrylate de 2-hydroxyéthyle, du méthacrylate de 2-hydroxyéthyle.

10. Feuille de polyester selon l'une quelconque des revendications 1 à 9, **caractérisée en ce que** l'indice de fusion (2, 16 kg/190 °C) (mesuré selon la norme DIN EN ISO 1133) des copolymères d'éthylène-ester d'acide acrylique se situe dans la plage de 0, 5 à 50 g/10 min.

11. Feuille de polyester selon l'une quelconque des revendications 1 à 10, **caractérisée en ce que** la couche de recouvrement (A) contient jusqu'à 25 % en poids d'additifs.

12. Procédé de fabrication d'une feuille de polyester selon la revendication 1, dans lequel les masses fondues correspondant à la feuille sont coextrudées à travers une filière plate, la feuille coextrudée obtenue de la sorte est appliquée à des fins de solidification sur un ou plusieurs cylindres refroidis, la feuille est ensuite étirée (orientée) biaxialement, la feuille étirée biaxialement est soumise à une thermofixation et éventuellement soumise, sur une couche de surface prévue pour le traitement, à un traitement de type corona ou à la flamme, refroidie et enroulée.

13. Utilisation d'une feuille selon la revendication 1 comme feuille de fond pour un module solaire.

14. Stratifié de feuille comportant au moins une feuille selon la revendication 1 et au moins une autre feuille, qui est différente de celle selon la revendication 1.

15. Module solaire comportant une feuille selon la revendication 1.
